**Europäisches Patentamt**

**European Patent Office**

**Office européen des brevets**

(11) Veröffentlichungsnummer: **0 411 599 A1**

# (12) EUROPÄISCHE PATENTANMELDUNG

(21) Anmeldenummer: **90114740.5**

(22) Anmeldetag: **01.08.90**

(51) Int. Cl.⁵: **C25D 21/08**

(30) Priorität: **05.08.89 DE 3925975**

(43) Veröffentlichungstag der Anmeldung:
**06.02.91 Patentblatt 91/06**

(84) Benannte Vertragsstaaten:
**BE CH DE DK ES FR GB IT LI LU NL SE**

(71) Anmelder: **SCHERING AKTIENGESELLSCHAFT Berlin und Bergkamen**
**Müllerstrasse 170/178 Postfach 65 03 11**
**D-1000 Berlin 65(DE)**

(72) Erfinder: **Haase, Peter**
**Lohweg 50**
**D-8501 Feucht(DE)**

(54) **Anordnung zur Spülung von in einer galvanischen Anlage behandelten Bauteilen.**

(57) Die Erfindung betrifft eine Anordnung zur Spülung von in einer galvanischen Anlage behandelten Bauteilen, insbesondere von mit Bohrungen versehenen Platten (2), wobei an jeder Seite des Bauteiles zumindest eine Sprühvorrichtung vorgesehen ist, die von oben nach unten entlang des Bauteiles und im Abstand davon geführt wird, so daß beide Seiten des Bauteiles mit einem Strahl der Reinigungsflüssigkeit besprüht werden. Um sämtliche Bereiche, insbesondere Bohrungen eines behandelten Bauteiles mit einem senkrecht oder nahezu senkrecht auftreffenden Sprühstrahl besprühen zu können, ist vorgesehen, daß die Sprühvorrichtungen (4, 5) ferner in horizontaler Richtung (10, 12) verschiebbar an der Anordnung geführt sind und daß ferner eine Transportvorrichtung (9) für diese Horizontalbewegung der Sprühvorrichtungen vorgesehen ist.

**EP 0 411 599 A1**

# ANORDNUNG ZUR SPÜLUNG VON IN EINER GALVANISCHEN ANLAGE BEHANDELTEN BAUTEILEN

Die Erfindung betrifft eine Anordnung gemäß dem Oberbegriff des Ansprüches 1. Derartige Bauteile, insbesondere ist dabei an mit Bohrungen versehene Leiterplatten gedacht, müssen nach ihrer galvanischen Behandlung von den noch anhaftenden Resten der Behandlungsflüssigkeit befreit werden. Dies geschieht durch Spritzen mit Hilfe eines Sprühstrahles, wobei besonders darauf zu achten ist, daß die in den meist recht kleinen Bohrungen noch befindlichen Reste der Behandlungsflüssigkeit vollständig entfernt werden. Hierzu ist es aus DE-GM 88 05 210 bekannt, zwei Sprühvorrichtungen vorzusehen, die auf jeder Seite eines plattenförmigen Bauteiles angebracht sind und senkrecht von oben nach unten an diesem entlangfahrend es besprühen. Dies hat den Nachteil, daß nur diejenigen Bohrungen vom Sprühstrahl senkrecht oder nahezu senkrecht getroffen werden, die sich auf einem ziemlich schmalen, den Sprühdüsen gegenüberliegenden Bereich befinden. Dagegen werden die seitlich von diesem Bereich gelegenen Bohrungen nur noch unvollständig vom Sprühstrahl durchsetzt, so daß auch nicht sämtliche Reste der Behandlungsflüssigkeit aus diesen Bohrungen herausgespült werden können.

Die Aufgabe der Erfindung besteht demgegenüber darin, eine Anordnung gemäß dem Oberbegriff des Ansprüches 1 so auszugestalten, daß sämtliche Bereiche, insbesondere Bohrungen eines behandelten Bauteiles min einem senkrecht oder einem nahezu senkrecht auftreffenden Sprühstrahl besprüht werden können.

Die Lösung dieser Aufgabe wird zunächst, ausgehend vom Oberbegriff des Ansprüches 1, in den Merkmalen des Kennzeichens des Ansprüches 1 gesehen. Hiermit ist sichergestellt, daß über den gesamten Bereich des Bauteiles, insbesondere eines plattenförmigen Bauteiles jeder Bereich und insbesondere jede Bohrung wenigstens einmal fast senkrecht vom Sprühstrahl getroffen und damit zuverlässig gespült wird.

Eine bevorzugte Ausführungsform ist Gegenstand des Anspruches 2, insbes. des Anspruches 3 und insbesondere des Anspruches 4. Hiermit wird ein Aufeinandertreffen zweier entgegengesetzt gerichteter Sprühstrahlen dieser beiden Sprühvorrichtungen in einer Bohrung oder einem Loch des behandelten Bauteiles weitgehend vermieden. Ein solches Aufeinandertreffen könnte nämlich zur Folge haben, daß der Rest an Behandlungsflüssigkeit nicht komplett ausgespült wird. Es hat sich gezeigt, daß der Verbrauch an Sprühflüssigkeit, insbesondere ist dabei an Wasser gedacht, auch nicht größer als beim erläuterten Stand der Technik.

Weitere Vorteile und Merkmale der Erfindung, sind den weiteren Unteransprüchen, sowie der nachfolgenden Beschreibung und der zugehörigen Zeichnung von erfindungsgemäßen Ausführungsmöglichkeiten zu entnehmen. In der Zeichnung zeigt:

Fig. 1: eine Draufsicht auf eine Anordnung nach der Erfindung,

Fig. 2: einen Schnitt gemäß der Linie II-II in Fig. 1,

Fig. 3: einen Schnitt gemäß der Linie III-III in Fig. 2,

Fig. 4: im vergrößerten Maßstab und einen Teilschnitt gemäß der Linie IV-IV in Fig. 2 Einzelheiten der Erfindung.

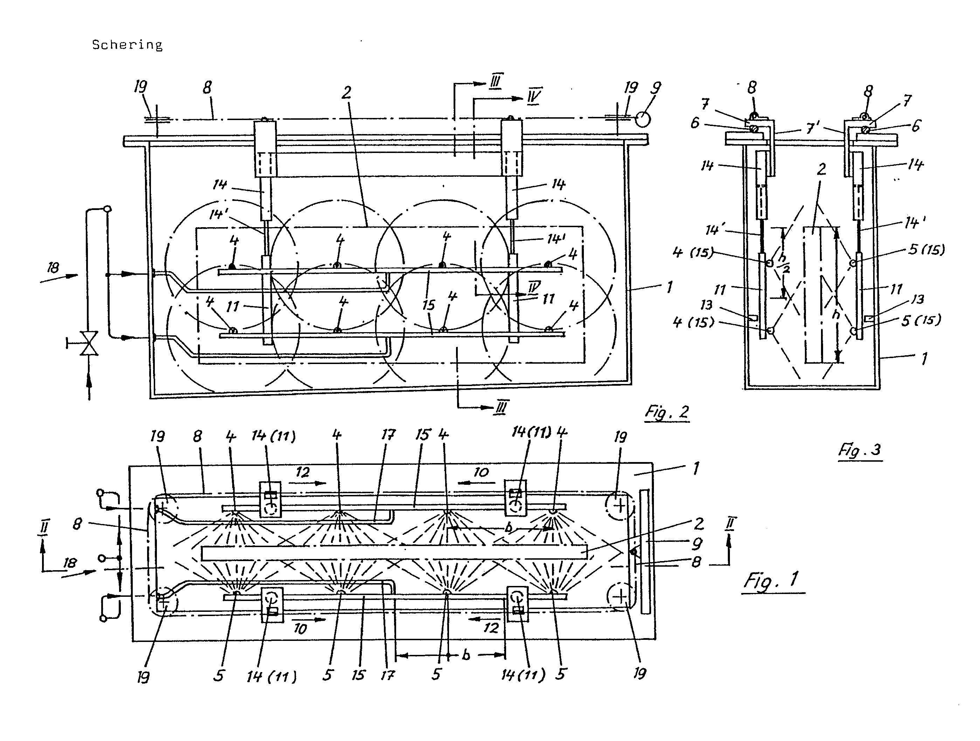

Beispielsweise in einem Behälter 1 wird das zu reinigende Bauteil, hier eine mit Bohrungen 3 versehene Leiterplatte 2, eingebracht. Es sind zumindest zwei Reihen von Sprühvorrichtungen 4, 5, nämlich zumindest eine Reihe von Sprühvorrichtungen 4 auf der einen und zumindest eine weitere Reihe von Sprühvorrichtungen 5 auf der anderen Seite der zu besprühenden Platte 2 vorgesehen (siehe insbesondere Fig. 1 Wie nachstehend noch näher erläutert wird, können die Sprühvorrichtungen 4, 5 jeweils unterschiedliche Positionen, und zwar sowohl in horizontaler Richtung als auch vertikaler Richtung einnehmen, wie es nachstehend näher erläutert ist.

Die Sprühvorrichtungen 4, 5 sind als Spritzdüsen ausgebildet (siehe auch Fig. 4) und an Zulaufrohren 15 befestigt, denen die Sprühflüssigkeit oder dergleichen zugeführt wird.

Zur Verlagerung der Sprühvorrichtungen 4, 5 in horizontaler Richtung sind an horizontal verlaufenden Streben 6 Schlitten 7 geführt, deren horizontale Bewegung mit Hilfe eines umlaufenden Seilzuges 8 erfolgt, der von einem Hydraulik-oder Druckluftzylinder 9 in beide Umlaufrichtungen bewegbar ist. An nach unten führenden Teilen oder Streben der Schlitten 7 sind auf jeder Seite der zu behandelnden Platte, und oberhalb der Zulaufrohre 15 zwei Hydraulik- oder Druckluftzylinder 14 vorgesehen, die jeweils über eine Schubstange 14' an senkrecht verlaufenden Verbindungsstreben 11 eingreifen. An diesen Verbindungsstreben 11 sind an jeder Seite der Leiterplatte 2 zwei Zulaufrohre 15 befastigt.: Somit können mittels des Zylinders 9 über die Teile 8, 7, 7', 14', 11 und 15 die jeweiligen Reihen 4, bzw 5 von Spritzdüsen um den horizontalen Hub b hin und her verschoben werden. Aufgrund der Verbindung der beiden Paare von Zulaufrohren über das gemeinsame Transportseil 8 erfolgt diese horizontale Hin- und Herbewegung der Spritzdüsenreihen 4 und der Spritzdüsenreihen 5 zwangsweise gegenläufig. Der Hub b, um welchen diese Hin- und Herbewegung erfolgt, kann am Zylinder 9 eingestellt werden. Falls erwünscht kann auch die Verstellung in horizontaler Richtung über den Hub b in einzelnen Schritten erfolgen. Die vorgenannte, entweder in einem Schritt oder in mehreren Schritten erfolgende Horizontalverstellung kann mit den nachstehend erläuterten, vertikalen Bewegungen der Sprühvorrichtungen 4, 5 in verschiedener Weise kombiniert werden. Insbesondere ist nach jedem horizontalen Schritt eine vertikale Bewegung 16 der Sprühvorrichtungen über zumindest die Hälfte der Höhe h des zu behandelnden Bauteiles) ggfls. auch über eine Höhe >h/2 durchführbar.

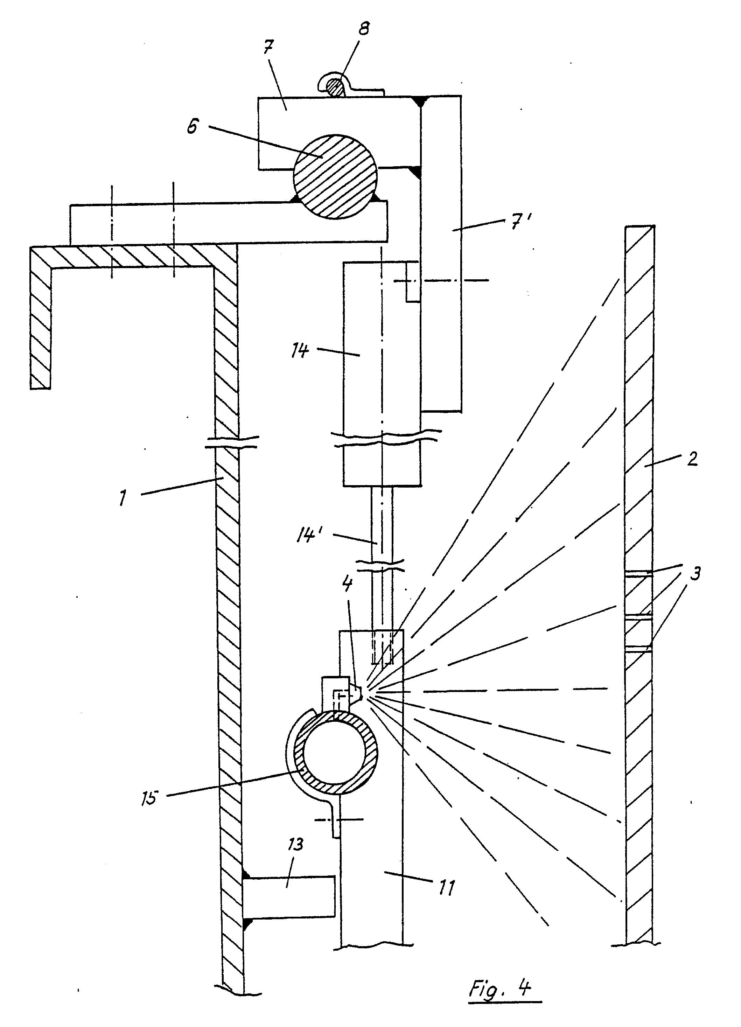

Fig. 3 zeigt, wie an jeder Seite, d.h. in dieser Zeichnung links und rechts der zu behandelnden Platte 2 sich jeweils zwei Reihen 4, bzw. 5 von Spritzdüsen übereinander befinden. Bei entsprechender Anordnung genügt es, wenn die Rohre 15 der beiden Reihen 4 und die Rohre 15 der beiden Reihen 5 jeweils um den vertikalen Hub h/2 in vertikaler Richtung 16 bewegt werden, wobei h gleich der Höhe der zu behandelnden Platte ist (siehe auch Fig. 1). Die diese Vertikalbewegung bewirkenden Hubzylinder 14 sind so eingestellt, daß die Vertikalbewegung der Spritzdüsenreihen 4 jeweils gegenläufig zu der der Spritzdüsenreihen 5 ist.

Die horizontalen und vertikalen Bewegungen der die Spritzdüsenreihen 4, 5 aufweisenden Rohre 15 können in beliebiger Weise miteinander gekoppelt bzw. gesteuert sein, so wie es gerade für den jeweiligen Reinigungsvorgang gewünscht wird. Z.B. kann man somit auch die jeweiligen Spritzdüsen eine wellen- oder sinusförmige Bewegung auf der zugehörigen Seite der zu behandelnden Platte oder dergleichen durchführen lassen.

Nach Beendigung des Sprühvorganges kann noch die Platte oder dergleichen mit Druckluft beaufschlagt werden, die entweder, nach Entfernen der Reinigungsflüssigkeit, durch das Rohr 15 oder aber durch ein anderes, in der Zeichnung nicht dargestelltes Rohr zugeführt werden kann. Die Zufuhr der Sprühflüssigkeit zu den beweglichen Rohren 15 erfolgt mittels Schläuche 17 von einer Verteileranlage 18 her. Ferner sind Umlenkrollen 19 für den Seilzug 8 vorgesehen.

Endanschläge für die Bewegungen der Zulaufrohre 15 in horizontaler und vertikaler Richtung sind nicht notwendig, da dies an den Zylindern 9, bzw. 14 eingestellt werden kann. Gemäß Fig. 4 können an der Innenwand des Gehäuses 1 Vorsprünge 13 vorgesehen sein, an denen die Streben 11 gleiten. Hierdurch wird der Spritzdruck der Düsen abgefangen.

Alle dargestellten Merkmale und ihre Kombinationen miteinander sind erfindungswesentlich.

## Ansprüche

1. Anordnung zur Spülung von in einer galvanischen Anlage behandelten Bauteilen, insbesondere von mit Bohrungen versehenen Platten, wobei an jeder Seite des Bauteiles zumindest eine Sprühvorrichtung vorgesehen ist, die von oben nach unten entlang des Bauteiles und im Abstand davon geführt wird, so daß beide Seiten des Bauteiles mit einem Strahl der Reinigungsflüssigkeit besprüht werden, dadurch gekennzeichnet , daß die Sprühvorrichtungen (4, 5) ferner in horizontaler Richtung (10, 12) verschiebbar an der Anordnung geführt sind und daß dazu eine Transportvorrichtung (9) für diese Horizontalbewegung der Sprühvorrichtungen vorgesehen ist.

2. Anordnung nach Anspruch 1, dadurch gekennzeichnet, daß die horizontalen Führungen und Bewegungen der beiden Sprühvorrichtungen (4, 5) miteinander derart gekoppelt sind, daß sich diese Sprühvorrichtungen in einander gegenläufigen Richtungen (10, 12) entlang der Seiten des Bauteiles (2) bewegen.

3. Anordnung nach Anspruch 1 oder 2, dadurch gekennzeichnet, daß die vertikalen Bewegungen (16) der beiden Sprühvorrichtungen (4, 5) miteinander derart gekoppelt sind, daß diese Sprühvorrichtungen sich in einander gegenläufigen Richtungen entlang der Seiten des Bauteiles (2) bewegen.

4. Anordnung nach.einem der Ansprüche 1. bis 3, gekennzeichnet durch eine Koppelung bzw. Steuerung der vertikalen (16) und der horizontalen (10, 12) Bewegungen jeder der Sprühvorrichtungen (4, 5) derart, daß sich die Sprühvorrichtungen sowohl in der Horizontalen, als auch in der Vertikalen zueinander in gegenläufigen Richtungen bewegen.

5. Anordnung nach einem der Ansprüche 1 bis 4, gekennzeichnet durch eine Kombination der vertikalen und der horizontalen Bewegung jeder der Sprühvorrichtungen (4, bzw. 5) derart, daß die Löcher oder Bohrungen (3) in dem behandelten Bauteil (2) von einem Sprühstrahl senkrecht oder nahezu senkrecht getroffen werden.

6. Anordnung nach einem der Ansprüche 1 bis 5, dadurch gekennzeichnet, daß auf jeder Seite des zu behandelnden Bauteiles eine oder mehrere Reihen von Sprühvorrichtungen (4, bzw. 5) übereinander angeordnet und starr miteinander verbunden sind, wobei an diesem Verbund die Mittel zur horizontalen und vertikalen Bewegung angreifen.

7. Anordnung nach Anspruch 6, dadurch gekennzeichnet, daß an jeder Seite des zu behandelnden Bauteiles ein oberes und ein unteres Zulaufrohr (15) vorgesehen ist, das einen Anschluß zur Reinigungsflüssigkeit besitzt und diese an die an den Rohren befestigten, als Spritzdüsen (4 bzw. 5) ausgebildeter Sprühvorrichtungen weitergibt und daß die beiden Zulaufrohre einer Seite mittels Streben (11) oder dergleichen fest miteinander verbunden sind.

8. Anordnung nach einem der Ansprüche 1 bis 7, dadurch gekennzeichnet, daß die Sprühvorrichtungen (4, 5), insbesondere der sie tragende Verbund mittels Schlitten (7) auf horizontalen Streben (6) geführt sind.

9. Anordnung nach einem der Ansprüche 1 bis 8, dadurch gekennzeichnet, daß für beide Sprühvorrichtungen (4 und 5), insbesondere den sie tragenden Verbund eine gemeinsamer, umlaufender Seilzug (8) vorgesehen ist, wobei der Antrieb (9) des Seilzuges in beiden Seilzugrichtungen (10, 12) erfolgt.

10. Anordnung nach Anspruch 8 oder 9, dadurch gekennzeichnet, daß an den Schlitten senkrechte Hubzylinder (14) angebracht sind, welche an den jeweiligen Verbund angreifen und diesen in vertikaler Richtung (16) bewegen.

11. Anordnung nach einem der Ansprüche 1 bis 10, dadurch gekennzeichnet, daß Druckluft über die Zufuhrrohre (15) bzw. über separate Zufuhrrohre speziellen Luft düsen zuführbar sind.

12. Anordnung nach einem der Ansprüche 1 bis 11, dadurch gekennzeichnet, daß Gleitvorsprünge (13) für die Anlage des Verbundes vorgesehen sind.

EP 0 411 599 A1

Schering

Fig. 3

Fig. 1

Fig. 2

5

Fig. 4

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | DE-A-2 332 547   (PILL)<br>* Seite 5, Zeilen 25-29; Figur 3 *<br>- - - | 1,2,7 | C 25 D 21/08 |
| X | US-A-3 282 273   (JOHNSTN)<br>* Spalte 1, Zeilen 16-23; Spalte 3, Zeilen 1-15 *<br>- - - - - | 1 | |

**RECHERCHIERTE SACHGEBIETE (Int. Cl.5)**

C 25 D
C 23 F

Der vorliegende Recherchenbericht wurde für alle Patentansprüche erstellt

| Recherchenort | Abschlußdatum der Recherche | Prüfer |
|---|---|---|
| Den Haag | 26 November 90 | NGUYEN THE NGHIEP |